# EUROPÄISCHE PATENTSCHRIFT

(11) **EP 3 570 973 B1**
(45) Veröffentlichungstag und Bekanntmachung des Hinweises auf die Patenterteilung: **06.10.2021**
(21) Anmeldenummer: 18700704.2
(22) Anmeldetag: 09.01.2018
(51) Int. Cl.: B22F 10/28, B22F 1/00, H01J 37/305, H01J 37/32, B33Y 10/00, B33Y 30/00, B33Y 40/00, B29C 64/153, B29C 64/35, B33Y 70/00, H01J 37/02, H01J 37/317, B22F 12/00, B22F 10/32, B22F 10/34, B22F 12/52, B33Y 40/10

(54) **VERFAHREN ZUR ADDITIVEN FERTIGUNG**
ADDITIVE MANUFACTURING PROCESS
PROCÉDÉ DE FABRICATION ADDITIVE

(30) Priorität: 17.01.2017 AT 5000517 U
(43) Veröffentlichungstag der Anmeldung: 27.11.2019
(73) Patentinhaber: Universität Innsbruck, 6020 Innsbruck (AT)
(72) Erfinder: BRAUN, Jakob, 6020 Innsbruck (AT); LEICHTFRIED, Gerhard Johannes, 6600 Reutte (AT); KASERER, Lukas, 6020 Innsbruck (AT); STAJKOVIC, Janko, 6020 Innsbruck (AT)
(74) Vertreter: Torggler & Hofinger Patentanwälte
(86) Internationale Anmeldenummer: PCT/AT2018/060007
(87) Internationale Veröffentlichungsnummer: WO 2018/132853

(56) Entgegenhaltungen:
- EP-A1- 3 178 585
- WO-A2-2016/011294
- DE-A1-102010 034 311
- US-A1- 2014 370 323

## Beschreibung

Die Erfindung betrifft ein Verfahren mit den Merkmalen des Anspruchs 1 und eine Vorrichtung mit den Merkmalen des Anspruchs 8.

Beispiele für additive Fertigungsverfahren sind SLM (Selective Laser Melting), EBM (Electron Beam Melting) und LMD (Laser Metal Deposition). Bei SLM und EBM werden die zu verfestigenden Pulverpartikel schichtweise in Pulverlagen aufgebracht und durch einen Hochenergiestrahl verfestigt. Bei LMD werden die Pulverpartikel über zumindest eine Düse dem Hochenergiestrahl zugeführt.

Das Verfestigen kann über zumindest teilweises Schmelzen und Erstarren oder über Sintern erfolgen.

Die Prozesskammer ist jener Bereich der Vorrichtung zum additiven Fertigen eines Bauteils, in welchem eine kontrollierte Atmosphäre oder ein Vakuum herstellbar und aufrecht erhaltbar sind. Die Prozesskammer kann durch ggf. gasdichte Unterteilungen in einzelne Abschnitte unterteilt sein.

Das additive Fertigen durch den Hochenergiestrahl erfolgt innerhalb eines Teilbereichs der Prozesskammer, welcher als Baubereich bezeichnet wird. Dieser kann, muss aber nicht durch Unterteilungen von anderen Abschnitten der Prozesskammer abgetrennt sein. Die zu verfestigenden Pulverpartikel werden zum Verfestigen in den Baubereich eingebracht.

Problematisch ist das Vorhandensein von Verunreinigungen (im Speziellen Sauerstoff), vor allem an Oberflächen der zu verfestigenden Pulverpartikel. Diese Verunreinigungen bewirken eine Reihe von Problemen, wie z. B.:
- Heißrissbildung während des additiven Fertigens des Bauteiles
- Verstärkung des Balling-Effekts durch Marangoni-Konvektion, verursacht durch Erniedrigung der Oberflächenspannung im Randbereich der Schmelzzone und daraus resultierend einen Materialfluss vom Randbereich der Schmelzzone in das Zentrum der Schmelzzone
- Reduktion der Bruchzähigkeit des gefertigten Bauteiles
- Schlechtes Fließverhalten der Pulverpartikel und damit ein ungleichmäßiges Aufbringen der Pulverpartikel in der Pulverlage (bei SLM und EBM)
- Verursachung einer Agglomeration der Pulverpartikel
- Unerwünschte Ausgaseffekte beim Verfestigen und dadurch Bildung von Gasporen. Das Vorhandensein von Gasporen wirkt sich u. a. negativ auf das Ermüdungsverhalten des gefertigten Bauteils aus.
- In Bezug auf EBM verursacht eine Verunreinigung in Form einer Oxidschicht auf den Pulverpartikeln eine kinetische Hemmung, da eine Oxidschicht eine Diffusionsbarriere bilden kann. Es kann auch zur Ausbildung isolierender Schichten kommen, die dann einen Fremdschichtwiderstand zwischen den Pulverpartikeln bilden.
- Reduktion der Korngrenzenfestigkeiten, was vor allem bei spröden Werkstoffen die Festigkeit des gefertigten Bauteils reduzieren kann.

Zur Behandlung dieser Schwierigkeiten sind verschiedene Lösungsansätze bekannt: Die DE 10 2010 034 311 A1 lehrt die Herstellung eines Pulvers, indem das Ausgangsmaterial in Ionen zerlegt wird und zu Mikro- und/oder Nanopartikeln agglomeriert, das in weiterer Folge verfestigt wird.

Nachteilig an diesem Verfahren ist die extrem aufwändige Anlagentechnik und dass Mikro- und Nanopartikel ein schlechtes Fließverhalten aufweisen, was die Ausbildung einer gleichmäßigen Pulverlage unmöglich macht. Das Zerlegen der Ausgangsmaterialien in Ionen führt zu großen Abdampfverlusten und zu einer Verunreinigung der Vorrichtung durch kondensiertes Material.

Es ist auch bekannt, ein sehr reines Pulver herzustellen, dieses unter Schutzgas zu lagern und unter Schutzgas in die Vorrichtung zur additiven Fertigung einzubringen. Dies macht eine sehr aufwändige Verfahrenstechnik notwendig und ist damit für eine wirtschaftliche Fertigung sehr nachteilig.

Die US 2014/370323 A1 offenbart ein Verfahren zur additiven Fertigung eines Bauteiles, bei welchem in einer Prozesskammer zu verfestigende Pulverpartikel mittels eines Hochenergiestrahls verfestigt werden, wobei vor dem Verfestigen die zu verfestigenden Pulverpartikel in der Prozesskammer in der Pulverlage durch ein Plasma gereinigt werden.

Aufgabe der Erfindung ist die Bereitstellung eines einfachen und kostengünstigen Verfahrens und einer einfachen und kostengünstigen Vorrichtung, bei welchen zumindest eines, vorzugsweise mehrere oder alle, der oben diskutierten Probleme hinsichtlich des Vorhandenseins von Verunreinigungen vermieden werden.

Diese Aufgabe wird durch ein Verfahren mit den Merkmalen des Anspruchs 1 und eine Vorrichtung mit den Merkmalen des Anspruchs 8 gelöst. Vorteilhafte Ausführungsformen der Erfindung sind in den abhängigen Ansprüchen definiert.

Der Begriff "Reinigung" ist nicht zwingend so zu verstehen, dass die zu verfestigenden Pulverpartikel keinerlei Verunreinigungen mehr aufweisen, sondern zumindest, dass allfällig noch vorhandene Verunreinigungen die weitere additive Fertigung nicht gravierend nachteilig beeinflussen.

Es ist vorgesehen, dass vor dem Verfestigen die zu verfestigenden Pulverpartikel in der Prozesskammer durch ein Plasma gereinigt werden. Durch die Plasmareinigung werden auf der Oberfläche der zu verfestigenden Pulverpartikel adsorbierte oder absorbierte Verunreinigungen, im Speziellen Sauerstoff oder Sauerstoffverbindungen (z. B. Hydroxide oder Metalloxide), zuverlässig entfernt.

Das Entfernen erfolgt unter anderem dadurch, dass durch die Plasmaeinwirkung eine Verunreinigungsschicht thermodynamisch instabil wird (durch Temperatur- und Druckänderung oder durch chemische Wechselwirkung mit den das Plasma konstituierenden Teilchen) oder dass durch die mechanische Einwirkung der das Plasma konstituierenden Teilchen Material abgetragen wird (physikalischer Materialabtrag).

Es ist weiters vorgesehen, dass die zu verfestigende Pulverpartikel vor dem Verfestigen als Pulverlage bereitgestellt werden und dass die zu verfestigenden Pulverpartikel vor der Bereitstellung als Pulverlage durch das Plasma gereinigt werden. Die Pulverlage weist typischerweise für SLM eine Lagendicke von 10 bis 50 Mikrometer und für EBM eine Lagendicke von 50 bis 150 Mikrometer auf.

Die Reinigung vor der Bereitstellung als Pulverlage kann beispielsweise im Bereich einer Zuführvorrichtung für die Vorratsvorrichtung oder in der Vorratsvorrichtung erfolgen. Dies hat insbesondere den Vorteil, dass die Prozesszeit für eine zuverlässige Reinigung der Pulverpartikel ausreichend lang ist und keine Verschlechterung der Wirtschaftlichkeit durch eine erhöhte Bauzeit des zu fertigenden Bauteils eintritt.

Die Erfindung bringt den Vorteil mit sich, dass die zu verfestigenden Pulverpartikel nicht bereits in reiner Form in die Vorrichtung zur additiven Fertigung eingebracht werden müssen, da vorhandene Verunreinigungen vor dem Verfestigen ohnehin durch die Reinigung mittels Plasma entfernt oder zumindest soweit reduziert werden, dass sie kein Problem mehr darstellen. Gewisse Verunreinigungen, z. B. mit Sauerstoff können gar nicht vermieden werden, wenn die Pulverpartikel vor dem Verfestigen mit einer unkontrollierten Atmosphäre in Kontakt kommen. Auch solche Verunreinigungen können im obigen Sinne entfernt werden.

Als zusätzlicher positiver Effekt der Erfindung kann ein Erwärmen der zu verfestigenden Pulverpartikel durch das Plasma vor dem Verfestigen zu einer Verbesserung der Eigenschaften des gefertigten Bauteils führen.

Es erfolgt keine Änderung des Aggregatzustandes der zu verfestigenden Pulverpartikel, die vor, während und nach der Reinigung durch das Plasma im festen Aggregatzustand vorliegen. In der DE 10 2010 034 311 A1 ist dies nicht gegeben.

Bevorzugt kommen metallische Pulverpartikel zum Einsatz, z. B. aus Titan oder Titanlegierungen, hochlegierten Stählen, Aluminium oder Aluminiumlegierungen, Refraktärmetalle oder Refraktärmetalllegierungen, Kobaltlegierungen oder Nickelbasis-Superlegierungen.

Bevorzugt wird als Hochenergiestrahl ein Laserstrahl (z. B. in einem Leistungsbereich von mindestens 100 Watt) oder ein Elektronenstrahl (z. B. in einem Leistungsbereich von mindestens 2 Kilowatt) verwendet.

Das durch die Plasmaerzeugungsvorrichtung erzeugte und für die Reinigung verwendete Plasma sollte für eine zufriedenstellende Reinigung mit einer ausreichenden Einwirkdauer auf die zu verfestigenden Pulverpartikel einwirken. Wie lange die ausreichende Einwirkdauer ist, hängt von der Art zu entfernenden Verunreinigungen, der Leistung und des Typs der Plasmaerzeugungsvorrichtung, Art und Druck des zur Plasmaherstellung eingesetzten Gases und dem gewünschten Reinheitsgrad der gereinigten Pulverpartikel ab. Eine für einen individuellen Fall ausreichende Einwirkdauer kann z. B. durch Versuchsserien oder Modellrechnungen bestimmt werden.

Die Plasmaerzeugungsvorrichtung ist gesondert von der Strahlerzeugungsvorrichtung zur Erzeugung des Hochenergiestrahls ausgebildet, wird also nicht durch diese gebildet.

Es kann vorgesehen sein, dass die zu verfestigenden Pulverpartikel eine sphärische Ausgangsform aufweisen.

Bei einem Ausführungsbeispiel der Erfindung ist vorgesehen, dass die zu verfestigenden Pulverpartikel eine Ausgangsform aufweisen und die Reinigung durch das Plasma im Wesentlichen unter Beibehaltung der Ausgangsform der zu verfestigenden Pulverpartikel erfolgt.

Dass die Ausgangsform im Wesentlichen beibehalten wird, ist so zu verstehen, dass zwar ein oberflächlicher Materialabtrag bei den Pulverpartikeln erfolgen kann, dieser jedoch so gleichmäßig ist, dass die Ausgangsform der Pulverpartikel erhalten bleibt, also z. B. in sphärischer Ausgangsform vorliegende Pulverpartikel nach der Reinigung durch das Plasma immer noch in sphärischer Ausgangsform vorliegen.

Unter sphärischer Ausgangsform sind folgende Formen zu verstehen:
- Kugelform
- gerundete Form (*engl.* rounded shape)
- agglomerierte oder aggregierte Primärpartikel (mit beliebiger Form), die als Agglomerat oder Aggregat eine Kugelform oder gerundete Form aufweisen.

Die Plasmaerzeugungsvorrichtung kann - zumindest teilweise oder vollständig - außerhalb oder innerhalb der Prozesskammer angeordnet sein.

Zur Erzeugung des Plasmas kann durch die Plasmaerzeugungsvorrichtung eine niederfrequente oder hochfrequente Wechselspannung eingesetzt werden, oder das Plasma kann durch elektromagnetische Strahlung im Mikrowellenbereich angeregt werden.

Bei einem Ausführungsbeispiel der Erfindung ist vorgesehen, dass in der Prozesskammer eine Prozessatmosphäre bereitgestellt wird und das Plasma aus der Prozessatmosphäre hergestellt wird. Dies stellt eine Möglichkeit zur Herstellung eines Niederdruckplasmas dar. Ein solches könnte natürlich auch auf Basis eines von der Prozessatmosphäre verschiedenen Gases erzeugt werden.

Die Verwendung eines Niederdruckplasmas bringt den Vorteil mit sich, dass gleichzeitig ein großer Bereich (z. B. der Pulverlage) gereinigt werden kann. Ein Niederdruckplasma kann von allen Seiten auf die Pulverpartikel einwirken und erzeugt so einen gleichmäßigeren Reinigungseffekt. Ein Niederdruckplasma ist von außerhalb der Prozesskammer anregbar. Eine Konvektionswalze (verursacht durch verdampfende Bestandteile der Pulverpartikel), die einen nachteiligen Effekt auf die Gleichmäßigkeit der Pulverlage hat, wird nicht oder nur in geringem Ausmaß ausgebildet.

Allgemein kann ein Plasma angeregt werden, durch:
- thermische Anregung
- Strahlungsanregung
- Anregung durch elektrostatische Felder
- Anregung durch elektromagnetische Felder

Es kann vorgesehen sein, dass ein Niederdruckplasma verwendet wird, welches durch kapazitive Einkopplung (z. B. durch einen Plattenreaktor erzeugt), induktive Einkopplung (z. B. durch eine Spule erzeugt) oder durch elektromagnetische Strahlung (z. B. durch ein Magnetron erzeugt) erzeugt wird.

Es kann auch vorgesehen sein, dass ein Atmosphärendruckplasma verwendet wird (vorteilhaft besonders bei LMD). Dieses kann auf an sich bekannte Weise erzeugt werden. Die Erzeugung des Plasmas kann unabhängig von einer allfällig vorhandenen Prozessatmosphäre oder auch bei Vakuum, z. B. auch außerhalb der Prozesskammer erfolgen.

Bei einem Ausführungsbeispiel der Erfindung ist vorgesehen, dass durch das Plasma ein ätzender Abtrag einer Oberfläche der zu verfestigenden Pulverpartikel erfolgt (Trockenätzprozess). Dabei geschieht der Materialabtrag vorzugsweise in einer chemischen Reaktion mit einem Bestandteil der Prozessatmosphäre. Der Materialabtrag kann jedoch auch durch ein plasmaunterstütztes, reaktives lonenätzen erfolgen. Der Ätzvorgang bei diesem Verfahren ist primär physikalischer Natur.

Bei einem Ausführungsbeispiel der Erfindung ist vorgesehen, dass in der Prozesskammer eine Schutzgasatmosphäre oder ein Vakuum aufrecht erhalten werden. Der Schutzgasatmosphäre kann ein Reaktivgas beigemengt werden oder es kann anstelle einer Schutzgasatmosphäre eine Reaktivgasatmosphäre vorgesehen sein.

Bei einem Ausführungsbeispiel der Erfindung ist vorgesehen, dass die zumindest eine Plasmaerzeugungsvorrichtung zumindest ein Elektrodenpaar aufweist, wobei der Baubereich für die additive Fertigung zumindest teilweise zwischen den Elektroden des Elektrodenpaars angeordnet ist. Eine der Elektroden des Elektrodenpaars kann durch einen Abschnitt einer Wandung der Prozesskammer oder der Baukammer gebildet sein. Eine der Elektroden des Elektrodenpaars ist geerdet, während an die andere Elektrode des Elektrodenpaars eine elektrische Wechselspannung anlegbar ist.

Es kann vorgesehen sein, dass die zumindest eine Plasmaerzeugungsvorrichtung zumindest eine Induktionsspule aufweist (welche mit einer elektrischen Wechselspannung beaufschlagbar ist), wobei der Baubereich zumindest teilweise innerhalb wenigstens einer Wicklung der zumindest einen Induktionsspule angeordnet ist.

Es kann vorgesehen sein, dass die zumindest eine Plasmaerzeugungsvorrichtung zumindest ein Magnetron aufweist, wobei das Magnetron innerhalb oder außerhalb der Prozesskammer angeordnet ist.

Bei einem Ausführungsbeispiel der Erfindung ist vorgesehen, dass eine Zubringvorrichtung zum Zubringen von zu verfestigenden Pulverpartikeln zum Baubereich vorgesehen ist (z. B. ein Rakel, bevorzugt mit Stahl-, Gummi- oder CFK-Lippe), wobei vorzugsweise vorgesehen ist, dass die Zubringvorrichtung mit der zumindest einen Plasmaerzeugungsvorrichtung in Verbindung steht und wenigstens eine Ausbringöffnung aufweist, über welche Plasma ausbringbar ist.

Bei einem Ausführungsbeispiel der Erfindung ist vorgesehen, dass durch die zumindest eine Plasmaerzeugungsvorrichtung ein Plasma vor oder in der Vorratsvorrichtung erzeugbar ist.

Bei einem Ausführungsbeispiel der Erfindung ist vorgesehen, dass die Prozesskammer zumindest einen den Baubereich aufweisenden ersten Abschnitt und einen zweiten Abschnitt umfasst, wobei der zweite Abschnitt koppelbar mit und entkoppelbar vom ersten Abschnitt ausgebildet ist, wobei der zweite Abschnitt im entkoppelten Zustand zumindest zeitweise gasdicht ausgebildet ist und im gekoppelten Zustand zu der im ersten Abschnitt vorliegenden Prozessatmosphäre oder einem vorliegenden Vakuum hin öffenbar ist und wobei durch die Plasmaerzeugungsvorrichtung ein Plasma im zweiten Abschnitt erzeugbar ist.

Es kann eine Prozessatmosphäre mit einem Druck p von 1 · 10⁻⁵ Millibar < p < 500 Millibar bereitgestellt werden.

Ausführungsbeispiele der Erfindung werden anhand der Figuren diskutiert. Es zeigen:
- Fig. 1: eine Vorrichtung mit Niederdruckplasma, erzeugt durch ein Magnetron
- Fig. 2a, 2b: eine Vorrichtung mit Niederdruckplasma, erzeugt durch ein Elektrodenpaar
- Fig. 3a, 3b: eine Vorrichtung mit einem Atmosphärendruckplasma
- Fig. 4: eine Vorrichtung mit einem Niederdruckplasma im Bereich einer Zuführvorrichtung für die Vorratsvorrichtung
- Fig. 5: eine Vorrichtung mit einem Atmosphärendruckplasma im Bereich der Vorratsvorrichtung
- Fig. 6a-c: Prozessdiagramme alternativer Ausführungsbeispiele eines erfindungsgemäßen Verfahrens

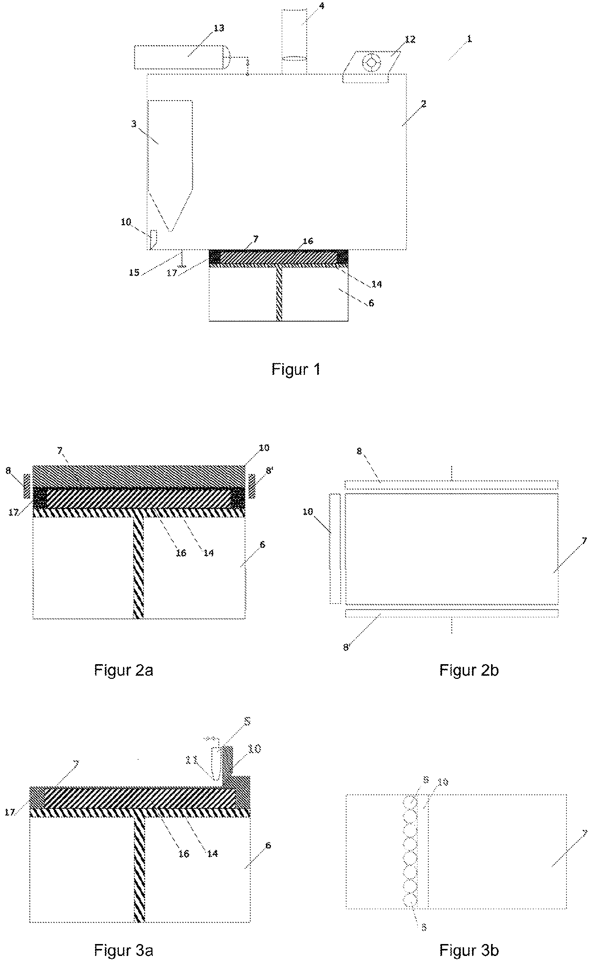

Fig. 1 zeigt in einer schematischen Schnittdarstellung eine Vorrichtung 1 zum additiven Fertigen eines Bauteiles mit einer Prozesskammer 2. Es ist eine Bereitstellungseinheit 13 zur Bereitstellung und Aufrechterhaltung einer Prozessatmosphäre in der Prozesskammer 2 vorgesehen. Es kann eine nicht dargestellte Druckreduktionsvorrichtung zur Bereitstellung und Aufrechterhaltung eines gegenüber der Umgebung abgesenkten Druckes oder eines Vakuums in der Prozesskammer 2 vorgesehen sein.

Die zu verfestigenden Pulverpartikel sind in einer Vorratsvorrichtung 3 bevorratet und können über eine Zubringvorrichtung 10 (hier ein Rakel) in einen Baubereich 6 eingebracht werden. Im konkreten Beispiel werden die zu verfestigenden Pulverpartikel im Baubereich 6 auf einer absenkbaren Bauplattform 14 in einer Pulverlage 7 schichtweise angeordnet. Jede Pulverlage 7 wird durch einen Hochenergiestrahl, der mittels einer Erzeugungsvorrichtung 4 erzeugbar ist, zumindest lokal verfestigt. So entsteht schichtweise das zu fertigende Bauteil 16. Das nicht durch den Hochenergiestrahl verfestigte Pulver 17 umgibt den Bauteil 16.

Gesondert von der Erzeugungsvorrichtung 4 für den Hochenergiestrahl ist eine Reinigungsvorrichtung vorgesehen, die eine Plasmaerzeugungsvorrichtung 5 (hier mit einem Magnetron 12) aufweist. Durch die Plasmaerzeugungsvorrichtung 5 ist aus der Prozessatmosphäre (z. B. Argonatmosphäre) im Baubereich 6 (genauer: im Bereich der Pulverlage 7 und deren unmittelbarer Umgebung) ein Plasma erzeugbar, welches die im Baubereich 6 angeordneten Pulverpartikel reinigt (nicht erfindungsgemäß). Das Gehäuse der Prozesskammer 2 ist über eine Erdung 15 geerdet.

Fig. 2a zeigt eine nicht erfindungsgemäße Vorrichtung 1 mit einer alternativen Ausbildung der Plasmaerzeugungsvorrichtung 5 im Bereich des Baubereichs 6 in einer Schnittdarstellung. Die nicht dargestellten Bereiche der Vorrichtung 1 sind abgesehen vom Nichtvorhandensein eines Magnetrons 12 so ausgebildet wie in Fig. 1. In Fig. 2a weist die Plasmaerzeugungsvorrichtung 5 ein Elektrodenpaar 8, 8' auf, wobei die Elektroden des Elektrodenpaars 8, 8' so neben der Pulverlage 7 angeordnet sind, dass der Rakel zwischen den Elektroden verfahren kann (vgl. die in Fig. 2b gezeigte Draufsicht auf den Baubereich 6).

Fig. 3a zeigt in einer Schnittdarstellung ein alternatives Ausführungsbeispiel einer Vorrichtung 1, bei welchem das für die Reinigung benötigte Plasma ein Atmosphärenplasma ist. Hier steht die Zubringvorrichtung 10 mit einer Vielzahl von Plasmaerzeugungsvorrichtungen 5 in Verbindung und weist eine Vielzahl von Ausbringöffnungen 11 auf, über welche Plasma direkt über der Pulverlage 7 und während des Aufbringens der Pulverlage 7 ausbringbar ist. Die Fig. 3b zeigt eine Draufsicht auf die Pulverlage 7 und die Vielzahl von Plasmaerzeugungsvorrichtungen 5. Die Plasmaerzeugungsvorrichtungen 5 sind an der Zubringvorrichtung 10 angebracht.

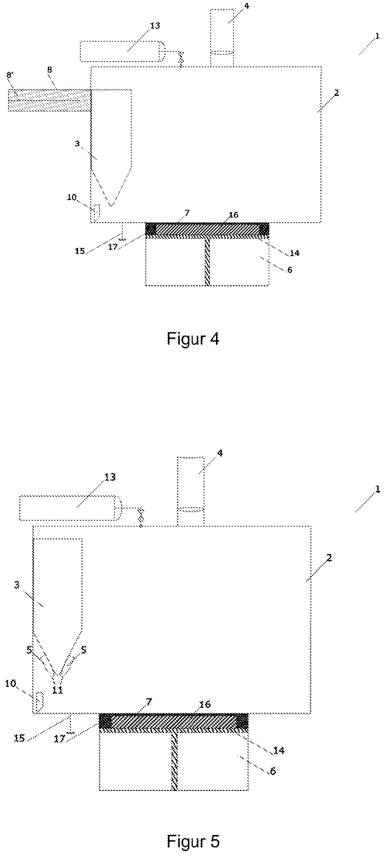

Fig. 4 zeigt in einer Schnittdarstellung ein alternatives Ausführungsbeispiel der Vorrichtung 1, bei welcher die Prozesskammer einen den Baubereich 6 aufweisenden ersten Abschnitt und einen zweiten Abschnitt (nämlich hier die Kammer der Plasmaerzeugungsvorrichtung 5) aufweist, wobei der zweite Abschnitt koppelbar mit und entkoppelbar vom ersten Abschnitt ausgebildet ist. Der zweite Abschnitt ist im entkoppelten Zustand zumindest zeitweise gasdicht ausgebildet und ist im gekoppelten Zustand zu der im ersten Abschnitt vorliegenden Prozessatmosphäre oder einem vorliegenden Vakuum hin öffenbar. Durch die Plasmaerzeugungsvorrichtung 5 ist ein Plasma im zweiten Abschnitt erzeugbar. Das Öffnen zum ersten Abschnitt hin erfolgt nach stattgefundener Reinigung. Die Plasmaerzeugungsvorrichtung 5 ist dabei als Kammer ausgebildet, wobei zur Plasmaerzeugung ein Elektrodenpaar 8, 8' vorgesehen ist (eine Elektrode 8 ist als zentral verlaufender Stab ausgebildet, die andere Elektrode 8' wird durch die Wandung der Kammer gebildet). Die Kammer kann mit den zu reinigenden Pulverpartikeln befüllt werden, welche nach der Reinigung in die Vorratsvorrichtung 3 eingebracht werden.

Fig. 5 zeigt in einer Schnittdarstellung ein alternatives Ausführungsbeispiel der Vorrichtung 1, bei welchem das für die Reinigung benötigte Plasma ein Atmosphärenplasma ist. Die Plasmaerzeugungsvorrichtung 5 mit der Ausbringöffnung 11 ist dabei unterhalb der Vorratsvorrichtung 3 angeordnet, sodass das Pulver beim Austrag aus der Vorratsvorrichtung 3 gereinigt wird.

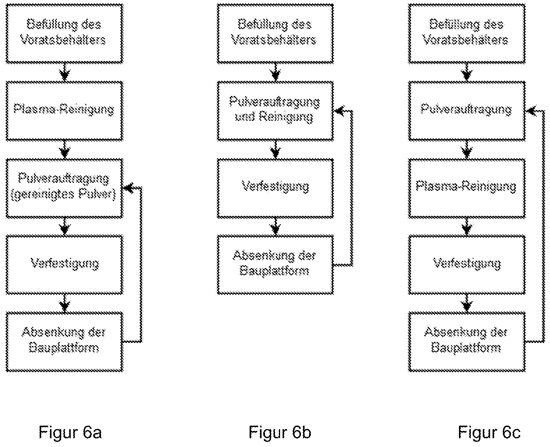

Fig. 6a zeigt ein Prozessdiagramm eines erfindungsgemäßen Verfahrens mit den folgenden Schritten:
- Einbringen von zu verfestigenden Pulverpartikel in eine Vorratsvorrichtung 3
- Reinigen der Pulverpartikel mit Plasma
- Aufbringen einer Pulverlage 7 aus gereinigten Pulverpartikel auf einer Bauplattform 14 im Baubereich 6 mittels einer Zubringvorrichtung 10
- Verfestigen der die Pulverlage 7 bildenden Pulverpartikel mit einem Hochenergiestrahl
- Absenken der Bauplattform 14
- Aufbringen einer Pulverlage 7 aus gereinigten Pulverpartikel auf der im vorigen Schritt zumindest teilweise verfestigten Schicht auf der Bauplattform 14 im Baubereich 6 mittels der Zubringvorrichtung 10 usw.

Fig. 6b zeigt ein Prozessdiagramm eines nicht erfindungsgemäßen Verfahrens mit den folgenden Schritten:
- Einbringen von zu verfestigenden Pulverpartikel in eine Vorratsvorrichtung 3
- Aufbringen einer Pulverlage 7 aus Pulverpartikel auf einer Bauplattform 14 im Baubereich 6 mittels einer Zubringvorrichtung 10 und Reinigen der Pulverpartikel während des Aufbringens
- Verfestigen der die Pulverlage 7 bildenden Pulverpartikel mit einem Hochenergiestrahl
- Absenken der Bauplattform 14
- Aufbringen einer Pulverlage 7 aus Pulverpartikel auf der im vorigen Schritt zumindest teilweise verfestigten Schicht auf der Bauplattform 14 im Baubereich 6 mittels der Zubringvorrichtung 10 und Reinigen der Pulverpartikel während des Aufbringens usw.

Fig. 6c zeigt ein Prozessdiagramm eines nicht erfindungsgemäßen Verfahrens mit den folgenden Schritten:
- Einbringen von zu verfestigenden Pulverpartikel in eine Vorratsvorrichtung 3
- Aufbringen einer Pulverlage 7 aus Pulverpartikel auf einer Bauplattform 14 im Baubereich 6 mittels einer Zubringvorrichtung 10
- Reinigen der in der Pulverlage angeordneten Pulverpartikel
- Verfestigen der die Pulverlage 7 bildenden Pulverpartikel mit einem Hochenergiestrahl
- Absenken der Bauplattform 14
- Aufbringen einer Pulverlage 7 aus Pulverpartikel auf der im vorigen Schritt zumindest teilweise verfestigten Schicht auf der Bauplattform 14 im Baubereich 6 mittels der Zubringvorrichtung 10
- Reinigen der in der Pulverlage angeordneten Pulverpartikel usw.

### Bezugszeichenliste:

- 1: Vorrichtung zum additiven Fertigung eines Bauteiles
- 2: Prozesskammer
- 3: Vorratsvorrichtung für zu verfestigende Pulverpartikel
- 4: Strahlerzeugungsvorrichtung zur Erzeugung eines Hochenergiestrahls
- 5: Plasmaerzeugungsvorrichtung zur Erzeugung eines Plasmas
- 6: Baubereich
- 7: Pulverlage
- 8, 8': Elektrodenpaar
- 9: Induktionsspule
- 10: Zubringvorrichtung
- 11: Ausbringöffnung der Plasmaerzeugungsvorrichtung
- 12: Magnetron
- 13: Bereitstellungseinheit für eine Prozessatmosphäre
- 14: Bauplattform
- 15: Erdung
- 16: Bauteil
- 17: Nicht verfestigtes Pulver

## Patentansprüche

1. Verfahren zur additiven Fertigung eines Bauteiles, bei welchem in einer Prozesskammer (2) zu verfestigende Pulverpartikel mittels eines Hochenergiestrahls verfestigt werden, wobei vor dem Verfestigen die zu verfestigenden Pulverpartikel in der Prozesskammer (2) durch ein Plasma gereinigt werden, **dadurch gekennzeichnet, dass** die zu verfestigenden Pulverpartikel vordem Verfestigen als Pulverlage (7) bereitgestellt werden, und dass die zu verfestigenden Pulverpartikel vor der Bereitstellung als Pulverlage (7) durch das Plasma gereinigt werden.

2. Verfahren nach Anspruch 1, wobei die zu verfestigenden Pulverpartikel eine sphärische Ausgangsform aufweisen.

3. Verfahren nach Anspruch 1 oder 2, wobei die zu verfestigenden Pulverpartikel eine Ausgangsform aufweisen und die Reinigung durch das Plasma im Wesentlichen unter Beibehaltung der Ausgangsform der zu verfestigenden Pulverpartikel erfolgt.

4. Verfahren nach wenigstens einem der vorangehenden Ansprüche, wobei in der Prozesskammer (2) eine Prozessatmosphäre bereitgestellt wird und das Plasma aus der Prozessatmosphäre hergestellt wird.

5. Verfahren nach wenigstens einem der vorangehenden Ansprüche, wobei für die Reinigung ein Niederdruckplasma oder ein Atmosphärendruckplasma verwendet wird.

6. Verfahren nach dem vorangehenden Anspruch, wobei ein Niederdruckplasma verwendet wird, welches durch kapazitive oder induktive Einkopplung oder durch elektromagnetische Strahlung erzeugt wird.

7. Verfahren nach wenigstens einem der vorangehenden Ansprüche, wobei durch das Plasma ein ätzender Abtrag einer Oberfläche der zu verfestigenden Pulverpartikel erfolgt.

8. Vorrichtung (1) zum additiven Fertigen eines Bauteiles, insbesondere nach einem Verfahren nach wenigstens einem der vorangehenden Ansprüche, mit:
- einer Vorratsvorrichtung (3) für zu verfestigende Pulverpartikel
- einer Strahlerzeugungsvorrichtung (4) zur Erzeugung eines Hochenergiestrahls, welcher auf einen Baubereich (6) gerichtet oder richtbar ist, in welchem die zu verfestigenden Pulverpartikel als Pulverlage (7) bereitstellbar sind,
- einer Prozesskammer (2), wobei vorzugsweise vorgesehen ist, dass die Prozesskammer (2) zumindest einen den Baubereich (6) aufweisenden ersten Abschnitt und einen zweiten Abschnitt umfasst, wobei der zweite Abschnitt koppelbar mit und entkoppelbar vom ersten Abschnitt ausgebildet ist, wobei der zweite Abschnitt im entkoppelten Zustand zumindest zeitweise gasdicht ausgebildet ist und im gekoppelten Zustand zu der im ersten Abschnitt vorliegenden Prozessatmosphäre oder einem vorliegenden Vakuum hin öffenbar ist und wobei durch die Plasmaerzeugungsvorrichtung (5) ein Plasma im zweiten Abschnitt erzeugbar ist,
**dadurch gekennzeichnet, dass** die Vorrichtung (1) eine Reinigungsvorrichtung aufweist, welche zumindest eine Plasmaerzeugungsvorrichtung (5) umfasst, durch die in der Prozesskammer (2) ein Plasma zum Reinigen der zu verfestigenden Pulverpartikel vor der Bereitstellung als Pulverlage (7) erzeugbar ist.

9. Vorrichtung nach dem vorangehenden Anspruch, wobei die zumindest eine Plasmaerzeugungsvorrichtung (5) zumindest ein Elektrodenpaar (8, 8') aufweist, wobei der Baubereich (6)
- zumindest teilweise zwischen den Elektroden des Elektrodenpaars (8, 8') angeordnet ist, oder
- außerhalb der Elektroden des Elektrodenpaars (8, 8') im Wirkungsfeld derselben angeordnet ist.

10. Vorrichtung nach Anspruch 8, wobei die zumindest eine Plasmaerzeugungsvorrichtung (5) zumindest eine Induktionsspule (9) aufweist, wobei der Baubereich (6)
- zumindest teilweise innerhalb wenigstens einer Wicklung der zumindest einen Induktionsspule (9) angeordnet ist, oder
- außerhalb der wenigstens einen Wicklung der zumindest einen Induktionsspule (9) im Wirkungsfeld derselben angeordnet ist.

11. Vorrichtung nach Anspruch 8, wobei die zumindest eine Plasmaerzeugungsvorrichtung (5) zumindest ein Magnetron (12) aufweist, wobei das Magnetron (12) innerhalb oder außerhalb der Prozesskammer (2) angeordnet ist.

12. Vorrichtung nach wenigstens einem der vorangehenden Ansprüche, wobei eine Zubringvorrichtung (10) zum Zubringen von zu verfestigenden Pulverpartikeln zum Baubereich (6) vorgesehen ist.

13. Vorrichtung nach dem vorangehenden Anspruch, wobei vorgesehen ist, dass die Zubringvorrichtung (10) mit der zumindest einen Plasmaerzeugungsvorrichtung (5) in Verbindung steht und wenigstens eine Ausbringöffnung (11) aufweist, über welche Plasma ausbringbar ist.

14. Vorrichtung nach wenigstens einem der vorangehenden Ansprüche, wobei durch die zumindest eine Plasmaerzeugungsvorrichtung (5) ein Plasma vor oder in der Vorratsvorrichtung (3) erzeugbar ist.

15. Vorrichtung nach wenigstens einem der vorangehenden Ansprüche, wobei die Plasmaerzeugungsvorrichtung (5) gesondert von der Strahlerzeugungsvorrichtung (4) zur Erzeugung des Hochenergiestrahls ausgebildet ist.

## Claims

1. A method of additive production of a component, in which powder particles to be solidified are solidified in a process chamber (2) by means of high-energy beam, wherein prior to the solidification step the powder particles to be solidified are cleaned in the process chamber (2) by a plasma, **characterised in that** the powder particles to be solidified are provided prior to solidification in the form of a powder layer (7) and that the powder particles to be solidified are cleaned by the plasma prior to being provided in the form of the powder layer (7).

2. A method according to claim 1 wherein the powder particles to be solidified are of a spherical initial shape.

3. A method according to claim 1 or claim 2 wherein the powder particles to be solidified are of an initial shape and cleaning by the plasma is effected substantially while maintaining the initial shape of the powder particles to be solidified.

4. A method according to at least one of the preceding claims wherein a process atmosphere is provided in the process chamber (7) and the plasma is produced from the process atmosphere.

5. A method according to at least one of the preceding claims wherein a low-pressure plasma or an atmospheric pressure plasma is used for the cleaning operation.

6. A method according to the preceding claim wherein a low-pressure plasma is used, which is produced by capacitive or inductive coupling or by electromagnetic radiation.

7. A method according to at least one of the preceding claims wherein etching removal of a surface of the powder particles to be solidified is effected by the plasma.

8. Apparatus (1) for the additive production of a component, in particular with a method according to at least one of the preceding claims, comprising
- a storage device (3) for powder particles to be solidified,
- a beam-generating device (4) for generating a high-energy beam which is or can be directed on to a building region (6) in which the powder particles to be solidified can be provided in the form of a powder layer (7),
- a process chamber (2), wherein it is preferably provided that the process chamber (2) includes at least a first portion having the building region (6) and a second portion, wherein the second portion can be coupled to and uncoupled from the first portion, wherein the second portion in the uncoupled state is at least temporarily gas-tight and in the coupled state can be opened towards the process atmosphere in the first portion or to an existing vacuum and wherein a plasma can be generated in the second portion by the plasma-generating device (5), **characterised in that** the apparatus (1) has a cleaning device
which includes at least one plasma-generating device (5), by which a plasma for cleaing the powder particles to be solidified can be generated in the process chamber (2) prior to being provided in the form of a plasma layer (7).

9. Apparatus according to the preceding claim wherein the at least one plasma-generating device (5) has at least one electrode pair (8, 8'), wherein the building region (6)
- is arranged at least partially between the electrodes of the electrode pair (8, 8'), or
- is arranged outside the electrodes of the electrode pair (8, 8') in the field of activity thereof.

10. Apparatus according to claim 8 wherein the at least one plasma-generating device (5) has at least one induction coil (9), wherein the building region (6)
- is arranged at least partially within at least one winding of the at least one induction coil (9), or
- is arranged outside the at least one winding of the at least one induction coil (9) in the field of activity thereof.

11. Apparatus according to claim 8 wherein the at least one plasma-generating device (5) has at least one magnetron (12), wherein the magnetron (12) is arranged within or outside the process chamber (2).

12. Apparatus according to at least one of the preceding claims wherein there is provided a feed device (10) for feeding powder particles to be solidified to the building region (6).

13. Apparatus according to the preceding claim wherein it is provided that the feed device (10) is in communication with the at least one plasma-generating device (5) and has at least one discharge opening (11), by way of which plasma can be discharged.

14. Apparatus according to at least one of the preceding claims wherein a plasma can be generated before or in the storage device (3) by the at least one plasma-generating device (5).

15. Apparatus according to at least one of the preceding claims wherein the plasma-generating device (5) is separate from the beam-generating device (4) for generating the high-energy beam.

## Revendications

1. Procédé de fabrication additive d'une pièce, selon lequel des particules de poudre à consolider sont consolidées dans une chambre de traitement (2) au moyen d'un faisceau de haute énergie, dans lequel les particules de poudre à consolider sont nettoyées dans la chambre de traitement (2) par un plasma avant consolidation, **caractérisé en ce que** les particules de poudre à consolider sont préparées comme couche de poudre (7) avant consolidation, et **en ce que** les particules de poudre à consolider sont nettoyées par le plasma avant préparation comme couche de poudre (7).

2. Procédé selon la revendication 1, dans lequel les particules de poudre à consolider comportent une forme initiale sphérique.

3. Procédé selon la revendication 1 ou 2, dans lequel les particules de poudre à consolider comportent une forme initiale et le nettoyage par le plasma s'effectue sensiblement en maintenant la forme initiale des particules de poudre à consolider.

4. Procédé selon au moins une des revendications précédentes, dans lequel une atmosphère de traitement est préparée dans la chambre de traitement (2) et le plasma est produit à partir de l'atmosphère de traitement.

5. Procédé selon au moins une des revendications précédentes, dans lequel un plasma à basse pression ou un plasma à pression atmosphérique est utilisé pour le nettoyage.

6. Procédé selon au moins une des revendications précédentes, dans lequel un plasma à basse pression est utilisé, lequel est généré par couplage capacitif ou inductif ou par rayonnement électromagnétique.

7. Procédé selon au moins une des revendications précédentes, dans lequel une ablation corrosive d'une surface des particules de poudre à consolider s'effectue par le plasma.

8. Dispositif (1) de fabrication additive d'une pièce, en particulier selon un procédé selon au moins une des revendications précédentes, doté :
- d'un dispositif de stockage (3) pour les particules de poudre à consolider
- d'un dispositif de génération de faisceau (4) destiné à générer un faisceau de haute énergie, lequel est ou peut être dirigé sur une zone de construction (6), au sein de laquelle les particules de poudre à consolider peuvent être préparées comme couche de poudre (7),
- d'une chambre de traitement (2), dans lequel il est de préférence prévu que la chambre de traitement (2) comprenne au moins une première section comportant la zone de construction (6) et une deuxième section, dans lequel la deuxième section est réalisée pour pouvoir être couplée à et découplée de la première section, dans lequel la deuxième section est, dans l'état découplé, réalisée de manière au moins temporairement étanche au gaz et, dans l'état couplé, peut être ouverte à l'atmosphère de traitement présente dans la première section ou à un vide présent et dans lequel un plasma peut être généré dans la deuxième section par le dispositif de génération de plasma (5),
**caractérisé en ce que** le dispositif (1) comporte un dispositif de nettoyage, lequel comprend au moins un dispositif de génération de plasma (5), par lequel un plasma peut être généré dans la chambre de traitement (2) afin de nettoyer les particules de poudre à consolider avant la préparation comme couche de poudre (7).

9. Dispositif selon la revendication précédente, dans lequel l'au moins un dispositif de génération de plasma (5) comporte au moins une paire d'électrodes (8, 8'), dans lequel la zone de construction (6)
- est disposée au moins partiellement entre les électrodes de la paire d'électrodes (8, 8'), ou
- est disposée à l'extérieur des électrodes de la paire d'électrodes (8, 8') dans le champ d'action de celles-ci.

10. Dispositif selon la revendication 8, dans lequel l'au moins un dispositif de génération de plasma (5) comporte au moins une bobine d'induction (9), dans lequel la zone de construction (6)
- est disposée au moins partiellement à l'intérieur d'au moins un enroulement de l'au moins une bobine d'induction (9), ou
- est disposée à l'extérieur de l'au moins un enroulement de l'au moins une bobine d'induction (9) dans le champ d'action de celle-ci.

11. Dispositif selon la revendication 8, dans lequel l'au moins un dispositif de génération de plasma (5) comporte au moins un magnétron (12), dans lequel le magnétron (12) est disposé à l'intérieur ou à l'extérieur de la chambre de traitement (2).

12. Dispositif selon au moins une des revendications précédentes, dans lequel un dispositif d'alimentation (10) est prévu afin d'amener les particules de poudre à consolider à la zone de construction (6).

13. Dispositif selon la revendication précédente, dans lequel il est prévu que le dispositif d'alimentation (10) soit en liaison avec l'au moins un dispositif de génération de plasma (5) et comporte au moins une ouverture de décharge (11) par le biais de laquelle le plasma peut être déchargé.

14. Dispositif selon au moins une des revendications précédentes, dans lequel un plasma peut être généré devant ou dans le dispositif de stockage (3) par l'au moins un dispositif de génération de plasma (5).

15. Dispositif selon au moins une des revendications précédentes, dans lequel le dispositif de génération de plasma (5) est réalisé comme séparé du dispositif de génération de faisceau (4) pour la génération du faisceau de haute énergie.
